# EUROPEAN PATENT SPECIFICATION

(11) **EP 2 633 970 B1**
(45) Date of publication and mention of the grant of the patent: **06.01.2016**
(21) Application number: 11836235.9
(22) Date of filing: 25.10.2011
(51) Int. Cl.: B29C 45/27, B01J 19/00, B29C 45/37, B81B 1/00, B81C 99/00, G01N 37/00

(54) **SHAPING DIE, MICROCHIP MANUFACTURED USING DIE, AND MANUFACTURING APPARATUS FOR MANUFACTURING MICROCHIP**
FORMMATRIZE, AUS DER MATRIZE HERGESTELLTER MIKROCHIP SOWIE VORRICHTUNG ZUR HERSTELLUNG DES MIKROCHIPS
MATRICE DE FORMAGE, MICROPUCE FABRIQUÉE À L'AUDE D'UNE MATRICE ET APPAREIL DE FABRICATION D'UNE MICROPUCE

(30) Priority: 29.10.2010 JP 2010243668
(43) Date of publication of application: 04.09.2013
(73) Proprietor: Konica Minolta, Inc., Tokyo 100-7015 (JP)
(72) Inventor: SEKIHARA, Kanji, Hachioji-shi Tokyo 192-8505 (JP)
(74) Representative: Gille Hrabal
(86) International application number: PCT/JP2011/074479
(87) International publication number: WO 2012/057102

(56) References cited:
- EP-A1- 2 095 928
- WO-A1-2009/101850
- JP-A- 10 323 865
- JP-A- 2004 322 379
- JP-A- 2009 109 272
- US-A- 4 880 587
- US-A1- 2007 296 114
- US-A1- 2009 295 023
- US-A1- 2010 173 148

## Description

### TECHNICAL FIELD

The present invention relates to a molding die, a microchip, and a manufacturing apparatus of the microchip.

### BACKGROUND ART

Conventionally, there has been practically used microchips (also referred to as micro analysis chips or micro fluid chips) or an apparatus called µTAS (Micro Total Analysis Systems) using the microchips, wherein a fine flow fluid passage or a circuit is formed on a silicon or glass substrate by using fine processing technology to conduct chemical reactions, separation, and analysis of a nucleic acid, a protein, and a liquid sample such as blood in a minute space. Such a microchip reduces the amounts of samples and reagents to be used and the discharge amount of waste fluid, thereby achieving a space-saving, portable, and inexpensive system.

A microchip is manufactured by attaching two members to each other, at least one of which is finely processed. Recently, a resin micro chip has been proposed to facilitate low-cost production. More specifically, the resin microchip is manufactured by bonding a resin substrate having a fluid passage groove on the surface to a resin cover (e.g., a film) for covering the fluid passage groove. Through holes are formed at the ends of the fluid passage groove on the substrate across the thickness direction, for example. The substrate having the fluid passage groove on the surface is bonded to the cover with the fluid passage groove inside. The bonding allows the cover to function as a lid for the fluid passage groove, and thus the fluid passage groove and the cover form a fluid passage. Thereby, a microchip including a fluid passage inside is manufactured. The through holes formed in the substrate link the fluid passage to the exterior of the microchip, thereby allowing the introduction and discharge of a liquid specimen via the through holes.

The resin substrate is manufactured by molding a melted resin.

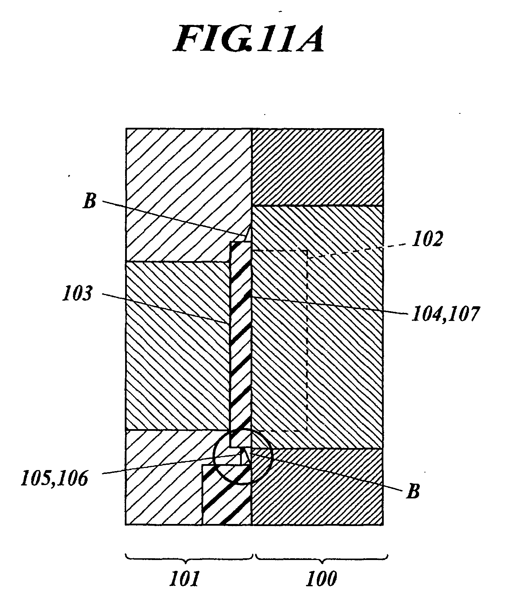

With reference to FIG. 11A, the molding die used for such molding includes a first die 100 and a second die 101 that is contactable with and separable from the first die 100. The first die 100 and the second die 101 contact with each other to form a molding space 104 that shapes resin 103 into a substrate 107 and a gate 105 that introduces the resin 103 into the molding space 104. In a molded product which is molded with such a molding die, a gate molded portion 106, which is a portion of the resin 103 cured in the gate 105 is coupled with a portion of the substrate 107. Thus, during substrate production, the gate molded portion 106 is cut off in the direction from a side opposite to a film bonding surface (the left in the drawing) to the film bonding surface (the right in the drawing). The area in the drawing defined by the dashed lines is an imaginary view of a film 102 to be attached to the substrate 107 after the molding of the substrate 107.

Regarding such resin molding, various techniques for preventing the generation of flashes B during resin molding have been recently developed to reduce the effect of the flashes B formed on the peripheries of a molded product (for example, refer to Patent Documents 1 to 4).

Document WO-A-2009/101850 describes the configuration to perform bonding so that a plastic substrate such as a film does not cover the surface around the gate portion where burrs K and/or bulges F are generated as described in claim 2 of WO-A-2009/101850, it is necessary to position and attach the film carefully so as not to cover around the gate of substrate. Thereby, WO-A-2009/101850 discloses a microchip with grooves, holes and a cover joint to the microchip.
Patent Document 1: Japanese Patent Application Laid Open Publication No. 2009-126151
Patent Document 2: Japanese Patent Application Laid Open No. 2001-079887
Patent Document 3: Japanese Patent Application Laid Open No. 2001-038759
Patent Document 4: Japanese Patent Application Laid Open No. H10-315254

### DISCLOSURE OF THE INVENTION

### PROBLEMS TO BE SOLVED BY THE INVENTION

The cutting of the gate molded portion 106 in the direction toward the film bonding surface, as described above, forms a nub or a burr 108 of the resin on the cut surface adjacent to the film bonding surface and/or a swell or a bulge 109 of the resin on the remaining part of the gate molded portion 106 adjacent to the first die 100, as illustrated in FIG. 11B. The burr 108 and the bulge 109 are at least ten times larger than the flash (the burr 108 is approximately ten to one hundred times larger than the flash B while the bulge 109 is approximately ten times larger than the flash B) and have adverse effects on the microchip during production and its use. The sizes and thicknesses of the film, the flash, the burr, and the bulge are exaggerated in the drawings for illustrative purposes.

The present invention has been conceived in light of the circumstances described above and an object of the present invention is to provide a molding die, a microchip, and a manufacturing apparatus of the microchip that can reduce adverse effects caused by burrs and bulges. The Problem is solved by the features of the independent claims. Further details of invention are defined in the dependent claims.

### MEANS FOR SOLVING THE PROBLEM

In order to solve the above problem, according to the present invention, there is provided a molding die for molding a substrate to be included in a microchip, wherein the microchip is formed by forming a fluid passage groove on one surface of the substrate and attaching a cover to the one surface, the molding die includes a first die and a second die contactable with and separable from the first die, a molding space for molding the substrate and a gate for introducing resin into the molding space are formed between the first die and the second die, a molding surface of the first die includes a first-die substrate molding region which molds the one surface of the substrate, a gate-defining region which defines the gate, and a rising region which is located between the gate-defining region and the first-die substrate molding region and extends from an edge of the first-die substrate molding region toward the second die, and the gate-defining region is closer to the second die than the first-die substrate molding region.

### EFFECT OF THE INVENTION

According to the present invention, a rising region rises from the edge of the first-die substrate molding region toward the second die between the first-die substrate molding region and the gate-defining region, and the gate-defining region is disposed closer to the second die than the first-die substrate molding region. Thus, the gate molded portion (portion of the resin cured in the gate) is disposed further inward than the one surface (surface joined with the cover) when the molded product is viewed from the first die. Thus, a burr and/or a bulge formed as a result of cutting off the gate molded portion in the direction from the second die to the first die can be positioned closer to the other surface than the one surface. Such positions of the burr and the bulge can reduce the adverse effects of the burr and the bulge.

### BRIEF DESCRIPTION OF DRAWINGS

[FIG. 1] This is an external configuration of an inspection apparatus.
[FIG. 2] This is a schematic view of an internal structure of the inspection apparatus.
[FIG. 3A] This is a schematic plan view of a microchip.
[FIG. 3B] This is a schematic perspective side view of the internal configuration of the microchip.
[FIG. 3C] This is a schematic perspective side view of the internal configuration of the microchip.
[FIG. 4A] This is a schematic plan view of a microchip.
[FIG. 4B] This is a schematic perspective side view of the internal configuration of the microchip.
[FIG. 4C] This is a schematic perspective side view of the internal configuration of the microchip.
[FIG. 5A] This is a schematic plan view of a microchip.
[FIG. 5B] This is a schematic perspective side view of the internal configuration of the microchip.
[FIG. 5C] This is a schematic perspective side view of the internal configuration of the microchip.
[FIG. 6] This is a side view of an apparatus for molding a substrate.
[FIG. 7A] This is a cross-sectional view of a substrate molding die.
[FIG. 7B] This is an enlarged view of a molded product indicated by the thick line in FIG. 7A.
[FIG. 8] This is a cross-sectional view of a substrate molding die according to a second embodiment.
[FIG. 9] This is a cross-sectional view of a substrate molding die according to a modification of the second embodiment.
[FIG. 10] This is a cross-sectional view of a substrate molding die according to a third embodiment.
[FIG. 11A] This is a cross-sectional view of a conventional substrate molding die.
[FIG. 11B] This is an enlarged view of a molded product indicated by the thick line in FIG.11A.

### EMBODIMENTS FOR CARRYING OUT THE INVENTION

Embodiments of the present invention will now be described with reference to the drawings. The present invention, however, should not be limited to the embodiments. In the drawings, the same or equivalent elements will be designated by the same reference numerals, without redundant descriptions.

### [First Embodiment]

### (1. Inspection Apparatus)

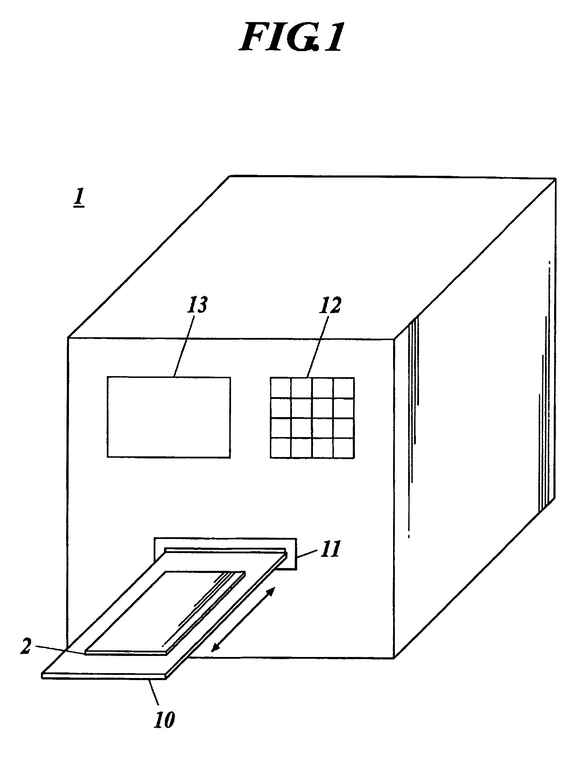

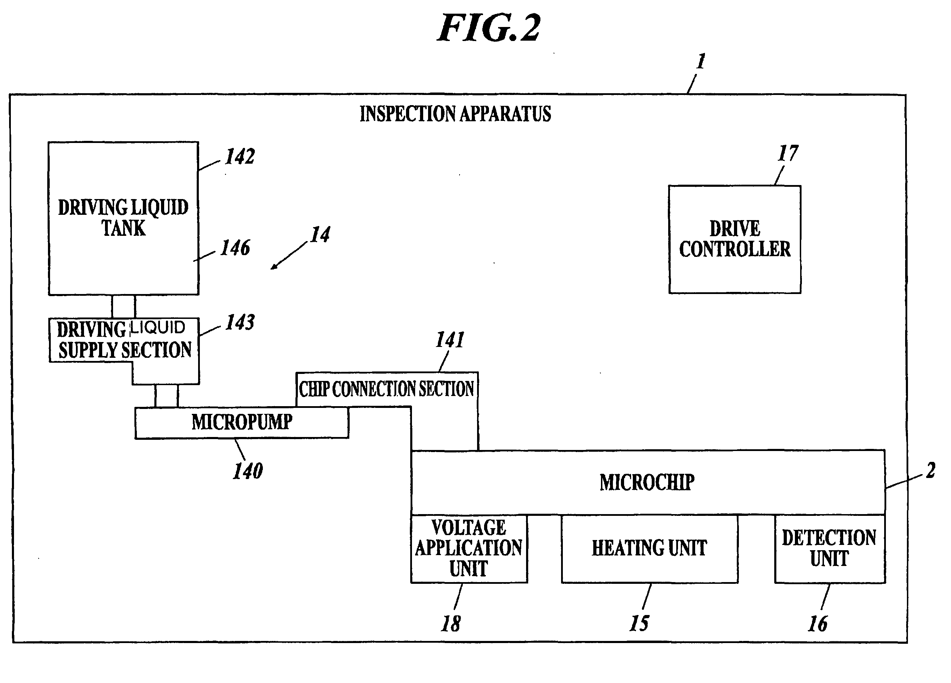

An inspection apparatus according to the embodiment will now be described with reference to FIGS. 1 and 2.

FIG. 1 is a perspective view illustrating an example of an external configuration of the inspection apparatus 1. FIG. 2 is a schematic view illustrating an example of an internal structure of the inspection apparatus 1.

As illustrated in FIG. 1, the inspection apparatus 1 includes a tray 10 on which a microchip 2 is placed, a conveying slit 11 through which the microchip 2 on the tray 10 is conveyed by a loading mechanism (not shown in the drawings), an operation unit 12 for inputting data, for example, of the details and subject of an inspection, a display unit 13 for displaying the results of the inspection and such like.

As illustrated in FIG. 2, the inspection apparatus 1 includes a fluid delivering unit 14, a heating unit 15, a voltage application unit 18, a detection unit 16, a drive controller 17 and such like.

### (1-1. Fluid Delivering Unit)

The fluid delivering unit 14 delivers fluid to/from the microchip 2 and is connected to the microchip 2, which is conveyed into the inspection apparatus 1 through the conveying slit 11. The fluid delivering unit 14 includes at least one micropump 140, a chip connection section 141, a driving liquid tank 142, an driving liquid supply section 143 and such like.

The fluid delivering unit 14 is provided with one or more micropumps 140 performing fluid delivery to and from the microchip 2 by injecting driving liquid 146 into the microchip 2 and sucking fluid, such as an assay sample, from the microchip 2. If a plurality of micropumps 140 are provided, the micropumps 140 can be driven independently or in conjunction with each other. If a medium, an analyte, a reagent, and other fluid are injected into the microchip in advance, fluid delivery by driving liquid is not always necessary and otherwise only the micropump may be operated to support the transfer of the medium. Alternatively, the micropump may be used exclusively for injection of a reagent and an analyte.

The micropump 140 is in communication with the microchip 2 via the chip connection section 141.

The driving liquid tank 142 retains the driving liquid 146 while supplying the driving liquid 146 to the driving liquid supply section 143. The driving liquid tank 142 is detachable from the driving liquid supply section 143 for refill of the driving liquid 146.

The driving liquid supply section 143 supplies the driving liquid 146 from the driving liquid tank 142 to the micropump 140.

As described above, in the fluid delivering unit 14, the microchip 2 is in communication with the micropump 140 via the chip connection section 141. The micropump 140 is driven to inject/suck the driving liquid 146 to/from the microchip 2 via the chip connection section 141. The analyte, the reagent and such like that are stored in multiple storage sections in the microchip 2 are delivered through the microchip 2 by the driving liquid 146. As a result, the analyte and the reagent are mixed in the microchip 2 to trigger a reaction for detection of a target substance or the diagnosis of a disease, for example.

### (1-2. Heating Unit)

The heating unit 15 generates thermal energy to heat the microchip 2 to several specific temperatures. For example, the heating unit 15 heats the microchip 2 to a thermal denaturation temperature of approximately 95°C, an annealing temperature of approximately 55°C, and a polymerizing temperature of approximately 70°C. Such heating facilitates gene amplification through PCR method. The heating unit 15 is configured by including an element that generates heat with electricity, such as a heater or a Peltier element, an element that lowers the temperature through water conduction, and such like.

### (1-3. Voltage Application Unit)

The voltage application unit 18 includes a plurality of electrodes. The electrodes are disposed in the liquid sample in the microchip 2 and directly apply a voltage to the liquid sample or are placed in contact with current-carrying portions 40, which are described below, and apply a voltage to the liquid sample via the after-mentioned current-carrying portions 40 for electrophoresis of the liquid sample in the microchip 2.

### (1-4. Detection Unit)

The detection unit 16 includes a light source such as light-emitting diode (LED) or laser beams and a light-receiving unit such as photodiode (PD), and optically detects a target substance contained in the fluid generated through a reaction in the microchip 2 in a predetermined area (detection area 200, which is described below) on the microchip 2. The light source and the light-receiving unit are positioned in a transmission arrangement or a reflection arrangement, whichever is more desirable.

### (1-5. Drive Controller)

The drive controller 17 includes a microcomputer and a memory (not shown in the drawings), and drives, controls and detects the components in the inspection apparatus 1.

### (2. Microchip)

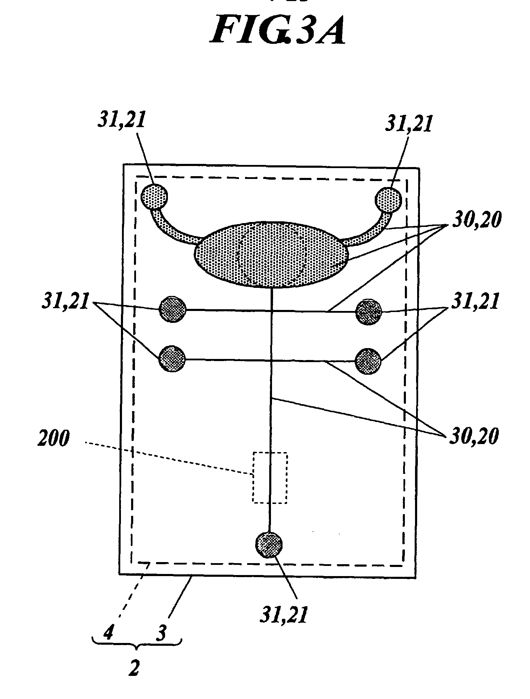

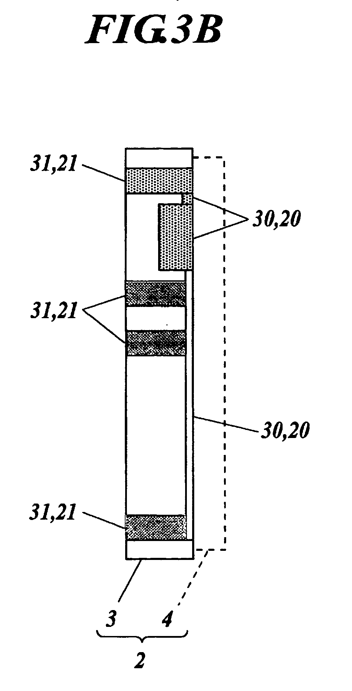

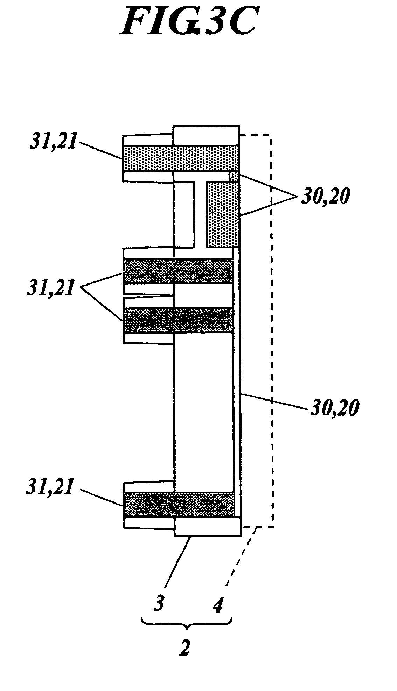

The microchip 2 according to this embodiment will now be described with reference to FIGS. 3A, 3B, and 3C.

FIGS. 3A, 3B, and 3C illustrate the microchip 2, where FIG. 3A is a plan view, and FIGS. 3B and 3C are perspective side views of the internal configuration.

With reference to FIGS. 3A and 3B, the microchip 2 includes a substrate 3 joined together with a film 4.

The substrate 3 is provided with fluid passage grooves 30 on the surface bonded to the film 4 (which hereinafter is referred to as "inner side surface 3A"). The fluid passage grooves 30 on the substrate 3 define micro fluid passages 20 in cooperation with the film 4 attached to the substrate 3. The micro fluid passages 20 include a detection area 200 in which the detection unit 16 of the inspection apparatus 1 detects a target substance. The micro fluid passages 20 (fluid passage grooves 30) having a width and depth within a preferred range of 10 to 200 µm require only small volumes of analytical samples and reagents and lead to excellent precision, transferability, and releasability of the mold; however, the micro fluid passages 20 can have any other width and depth. The width and depth of the micro fluid passages 20 may be selected in accordance with the usage of the microchip. The cross-section of the micro fluid passages 20 may be rectangular or rounded.

The substrate 3 has a plurality of through holes 31 in the thickness direction. These through holes 31 are formed at the ends and intermediate portions of the fluid passage grooves 30. The substrate 3 joined with the film 4 defines openings 21 through which the micro fluid passages 20 are in communication with the exterior of the microchip 2. The openings 21 are connected to the chip connection section 141 (tubes or nozzles) of the fluid delivering unit 14 of the inspection apparatus 1 to introduce/discharge a gel or liquid sample or a buffer solution to/from the micro fluid passages 20. Electrodes of the voltage application unit 18 of the inspection apparatus 1 can be disposed in the openings 21. The openings 21 (through holes 31) may have a circular, rectangular, or any other shape. As illustrated in FIG. 3C, for example, the through holes 31 may be surrounded by a cylindrical protrusion on the surface in the side opposite to the inner side surface 3A (hereinafter, referred to as "outer side surface 3B") of the substrate 3 to facilitate connection with the chip connection section 141.

The film 4 corresponds to the cover according to the present invention and is formed in a sheet in this embodiment. Micro fluid passages and holes may also be formed on the film 4. The film 4, however, should not be excessively thick to ensure bonding with the substrate 3. Depending on the type of analyte, reagent or inspection, electrophoresis of the sample may be conducted in the micro fluid passages 20 by disposing the electrodes of the voltage application unit 18 in the openings 21 (through holes 31) and applying a voltage.

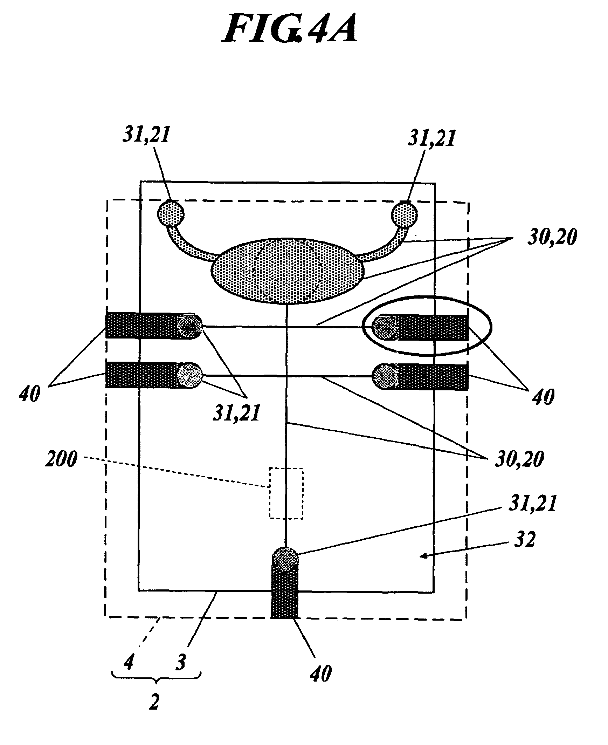

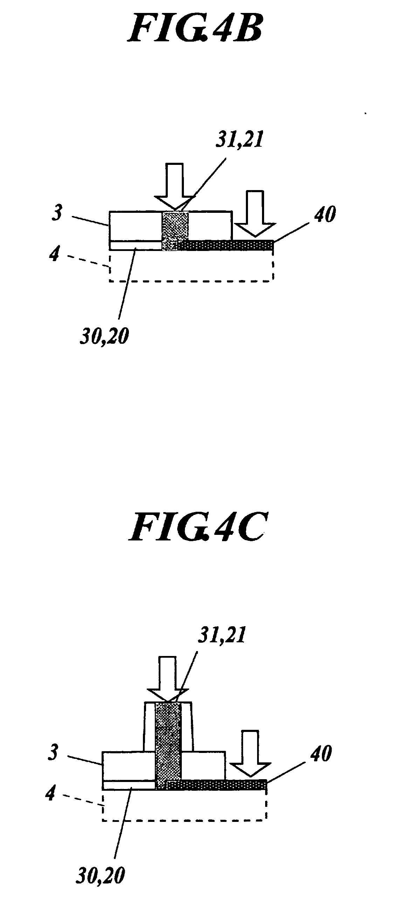

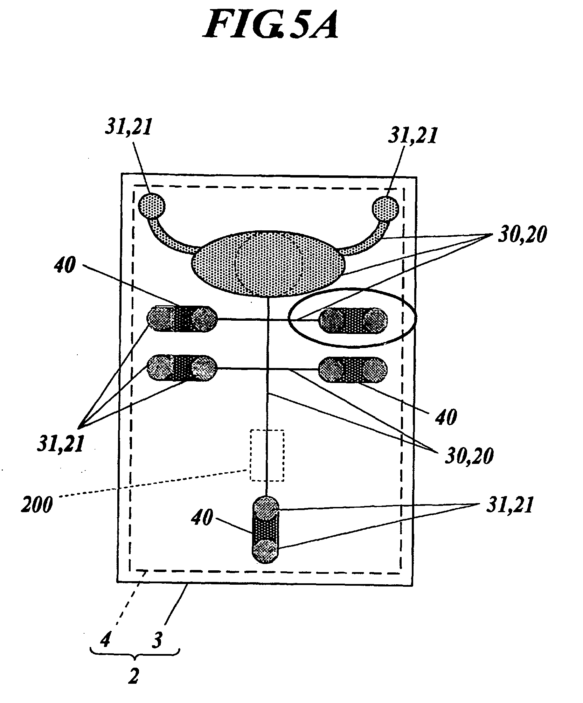

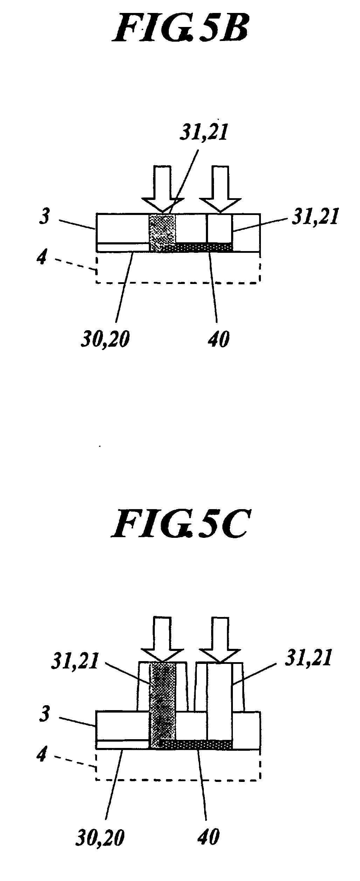

The openings 21 may be positioned and shaped as illustrated in FIGS. 4A, 4B, 5A, and 5B, for example, or in any other way. FIGS. 4B and 5B are perspective views of the internal configuration of the areas defined by thick lines in FIGS. 4A and 5A, respectively. Referring to the microchip 2 illustrated in FIGS. 4A, 4B, and 4C, conductive current-carrying portions 40 are provided on the surface, which faces the substrate 3, of the film 4 so as to extend from positions facing the through holes 31 to the edges. The conductive current-carrying portions 40 may be patterned, e. g. , printed, on the film 4. With such a microchip 2, voltage can be applied to the fluid in the micro fluid passages 20 from the edges of the film 4 via the conductive portions 40 (refer to the arrow on the right side in Fig. 4B) without disposing the electrodes inside the through holes 31 (openings 21). Thus, even in a case where a plurality of microchips 2 are to be used in sequence, the subsequent microchip 2 can be prevented from contamination due to attachment of the liquid sample to the electrodes. Referring to the microchip 2 illustrated in FIGS. 5A, 5B, and 5C, the through holes 31 are formed alongside at the ends of the fluid passage grooves 30 and at positions adjacent to the ends while each current-carrying portion 40 straddles two adjacent through holes 31. With such a microchip 2, a liquid sample or any other fluid can be supplied or discharged through the through holes 31 (openings 21) at the ends of the fluid passage grooves 30 (refer to the arrow on the left side in FIG. 5B), and a voltage can be applied to the fluid in the micro fluid passages 20 from the adjacent through holes 31 (openings 21) via the current-carrying portion 40 (refer to the arrow on the right side in FIG. 5B). Thus, even in a case where a plurality of microchips 2 are to be used in sequence, the subsequent microchip 2 can be prevented from contamination due to the attachment of the liquid sample to the electrodes. With such a microchip 2, the through holes 31 may also be surrounded by cylindrical protrusions on the outer side surface 3B of the substrate 3, as illustrated in FIGS. 4C and 5C, to facilitate connection with the chip connection section 141.

The substrate 3 and the film 4 may have any external shape that facilitates handling and analysis. The preferred shape in a plan view is a square or a rectangle. Each side is, for example, within the range of 10 to 200 mm. Alternatively, the side may be within the range of 10 to 100 mm. The substrate 3 having the fluid passage grooves 30 has a thickness in the range of preferably 0.2 to 5 mm, more preferably 0.5 to 2 mm to achieve excellent moldability. The film 4 serving as a lid (cover) covering the fluid passage grooves has a thickness within the range of preferably 30 to 300 µm, more preferably 50 to 150 µm.

The substrate 3 and the film 4 are formed of resin. The resin of the substrate 3 and the film 4 should have excellent moldability (transferability and releasability), excellent transparency, and low autofluorescence to ultraviolet and visible rays. The substrate 3 and the film 4 are formed of, for example, thermoplastic resin. Preferred thermoplastic resins include polycarbonates, polymethyl methacrylate, polystyrene, polyacrylonitrile, polyvinyl chloride, polyethylene terephthalate, nylon 6, nylon 66, polyvinyl acetate, polyvinylidene chloride, polypropylene, polyisoprene, polyethylene, polydimethylsiloxane, cyclic polyolefins and such like. The resins particularly preferred are polycarbonates, polymethyl methacrylate and cyclic polyolefins. The substrate 3 and the film 4 may be formed of the same material or different materials. The substrate 3 and the film 4 made of the same material will have high compatibility, promoting bonding after melting.

The substrate 3 and the film 4 are joined together by heat bonding. For example, the substrate 3 and the film 4 are joined by heating with a heated plate, hot air, a hot roller, ultrasonic sound, vibration, or a laser beam. For example, the substrate 3 and the film 4 are disposed between heated plates of a hot press and pressed between the heated plates for a predetermined time to be bonded to each other. The pressed film 4 serves as a lid (cover) of the fluid passage grooves 30, and the fluid passage grooves 30 and the film 4 define the micro fluid passages 20 of the microchip 2. Heat bonding of the substrate 3 and the film 4 is only required at the interface of the substrate 3 and the film 4. Ultrasonic waves, vibration or a laser beam can heat only the interface.

### (3. Manufacturing Apparatus of Microchip)

The manufacturing apparatus of a microchip 2 will now be described.

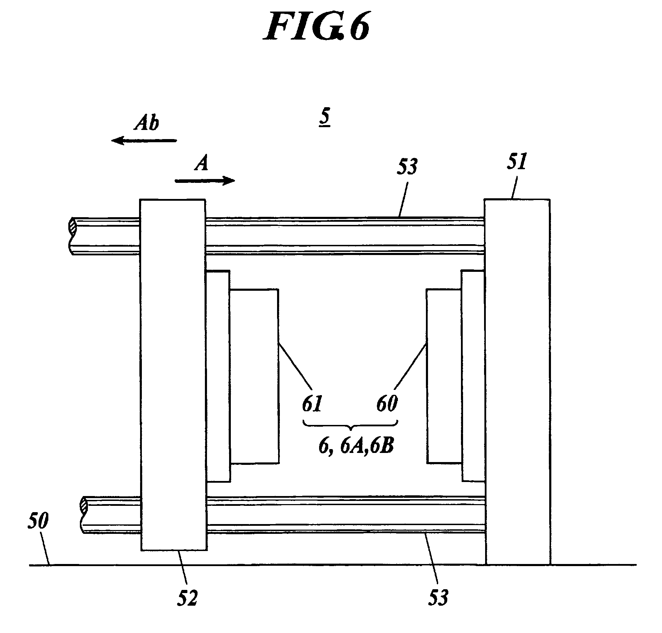

The manufacturing apparatus of the microchip 2 joins the substrate 3 with the film 4 which are preliminarily prepared to form a microchip 2. The apparatus includes a molding unit 5 for preparing the substrate 3, such as that illustrated in FIG. 6.

The molding unit 5 includes a fixed platen 51 disposed on a base 50 and a movable platen 52.

The fixed platen 51 is a flat plate vertically disposed on the base 50. Columnar tie bars 53 are disposed at the four corners of the fixed platen 51 such that the tie bars 53 extend orthogonal to the fixed platen 51.

The movable platen 52 is a flat plate disposed parallel to the fixed platen 51 and is supported by the tie bars 53 disposed at the four corners of the fixed platen 51. The movable platen 52 is guided along the tie bars 53 with a driving mechanism (not shown in the drawings) in the horizontal direction (in the directions indicated by arrows A and Ab in the drawing), i.e., toward or away from the fixed platen 51.

A molding die 6 is disposed between the fixed platen 51 and the movable platen 52. The movement of the movable platen 52 in the direction indicated by arrow A causes clamping of the molding die 6, whereas the movement of the movable platen 52 in the direction indicated by arrow Ab causes opening of the molding die 6.

### (3-1. Molding Die)

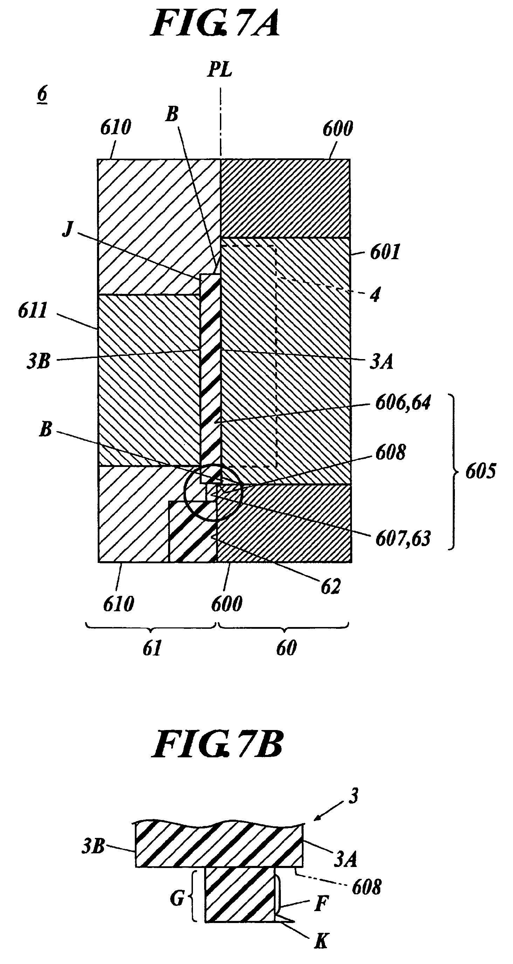

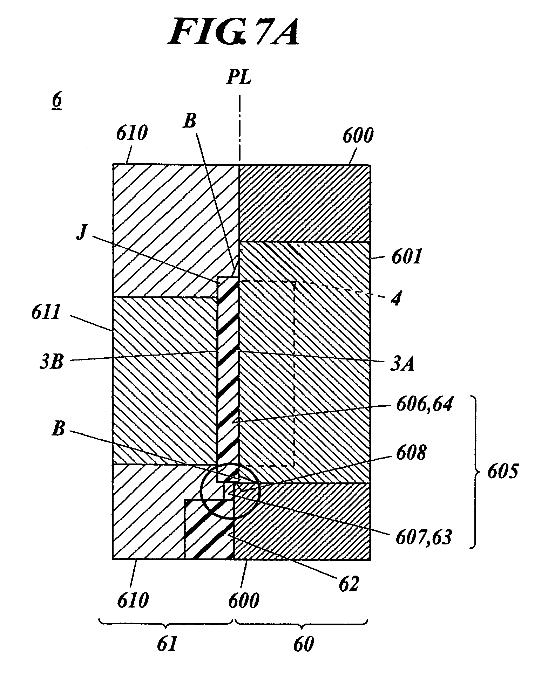

FIG. 7A is a schematic cross-sectional view of the molding die 6 having a molding space filled with resin.

With reference to the drawing, the molding die 6 is an injection mold configured by including a fixed die 60 as a first die and a movable die 61 as a second die which moves toward or away from the fixed die 60. The fixed die 60 and the movable die 61 contact with each other to form a molding space 64 for molding melted resin J into the shape of the substrate 3. A runner 62 and a gate 63 for introducing the melted resin J to the molding space 64 are formed between the fixed die 60 and the movable die 61. The runner 62 is connected to an injection unit via a sprue (not shown in the drawings). The molding space 64 is filled with the melted resin J from the runner 62 through the gate 63.

The fixed die 60 shapes a portion of the inner side surface 3A (surface adjacent to the film 4) of the substrate 3 and is fixed to the fixed platen 51.

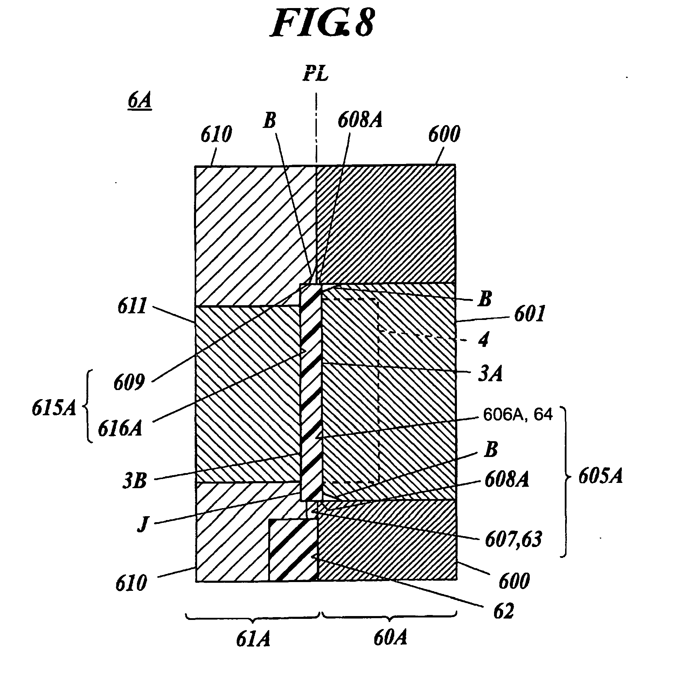

The fixed die 60 has a fixed-die molding surface 605. The drawing illustrates an imaginary view of a film 4 to be joined with the substrate 3 after molding. The thickness of the film 4 is exaggerated for illustrative purposes. The thickness of the film 4 is exaggerated in the same way in FIGS. 8 to 10.

The fixed-die molding surface 605 includes a fixed-die substrate molding region 606, a gate-defining region 607, and a rising region 608. The fixed-die substrate molding region 606 shapes the inner side surface 3A of the substrate 3 and, in this embodiment, extends along the same plane as a parting line PL of the molding space 64.

The gate-defining region 607 corresponds to a portion of the fixed die 60 defining the gate 63 and shapes the resin 103 cured in the gate 63 (hereinafter referred to as "gate molded portion G") adjacent to the fixed die 60.

The rising region 608 is disposed between the gate-defining region 607 and the fixed-die substrate molding region 606 and extends from the edge of the fixed-die substrate molding region 606 toward the movable die 61 to shape a portion of the peripheral side surface of the substrate 3. The gate-defining region 607 is disposed closer to the movable die 61 than the fixed-die substrate molding region 606.

In this embodiment, the fixed die 60 includes an annular peripheral piece 600 and a columnar central piece 601 fit inside the peripheral piece 600. The gate-defining region 607 is provided on the peripheral piece 600, while the fixed-die substrate molding region 606 is provided on the central piece 601. The rising region 608 is provided along a portion (adjacent to the gate 63) of the circumference of the interface between the peripheral piece 600 and the central piece 601.

The movable die 61 shapes the outer side surface 3B (remote from the inner side surface 3A) of the substrate 3 and is fixed to the movable platen 52.

The movable die 61 includes an annular peripheral piece 610 and a columnar central piece 611 which is fitted inside the peripheral piece 610.

The peripheral piece 610 shapes the peripheral portion of the outer side surface 3B of the substrate 3 and the peripheral side surface of the substrate 3, while the central piece 611 shapes the center portion of the outer side surface 3B. The movable die 61 has an ejection pin (not shown in the drawings) that is ejectable from the molding surface to release the molded product from the movable die 61.

By the fixed die 60 and the movable die 61 consisting of a central piece and a peripheral piece, only the central piece including the microstructures such as the micro fluid passages can be replaced. This reduces costs of the entire mold and readily allows modifications in the fluid passage structure.

In the molding die 6, flashes B of approximately 20 µm are formed, for example, on the contacting portion between the fixed die 60 and the movable die 61 and on the contacting portion between the peripheral piece 600 and the central piece 601 in the fixed die 60.

### (3-2. Manufacturing Method of Substrate)

A manufacturing method of the substrate 3 with the molding die 6 will now be described.

The melted resin J is injected to the molding space 64 from the runner 62 through the gate 63 and is molded under pressure inside the molding space 64.

When the molded product is cooled to a specific temperature, the movable die 61 is separated from the fixed die 60, and the molded product is released from the fixed die 60.

The ejection pin is ejected from the movable die 61 to release the molded product from the movable die 61.

The gate molded portion G is cut off from the molded product to acquire the substrate 3.

According to the embodiment, the rising region 608 extends from the edge of the fixed-die substrate molding region 606 toward the movable die 61 between the fixed-die substrate molding region 606 and the gate-defining region 607 of the fixed-die molding surface 605, and the gate-defining region 607 is disposed closer to the movable die 61 than the fixed-die substrate molding region 606. Thus, the gate molded portion G is disposed further inward than the inner side surface 3A when the molded product is viewed from the inner side surface 3A, as illustrated in FIG. 7B. A burr K and/or a bulge F formed as a result of cutting off the gate molded portion G in the direction from the movable die 61 to the fixed die 60 are positioned closer to the outer side surface 3B than the inner side surface 3A. Such positions of the burr K and the bulge F can reduce the adverse effects of the burr K and the bulge F.

### [Second Embodiment]

The second embodiment of the present invention will now be described with reference to FIG. 8.

FIG. 8 is a schematic cross-sectional view of a molding die 6A in the embodiment.

With reference to the drawing, the molding die 6A includes a fixed die 60A and a movable die 61A, alternative to the fixed die 60 and the movable die 61 according to the embodiment described above.

A fixed-die molding surface 605A in the fixed die 60A includes a rising region 608A, alternative to the rising region 608 according to the embodiment described above.

The rising region 608A surrounds the fixed-die substrate molding region 606 and shapes the entire peripheral side surface of a portion of the substrate 3 adj acent to the inner side surface 3A.

A movable-die molding surface 615A of the movable die 61A includes a movable-die substrate molding region 616A and a rising region 609.

The movable-die substrate molding region 616A shapes the outer side surface 3B of the substrate 3.

The rising region 609 extends from the edge of the movable-die substrate molding region 616A toward the fixed die 60A and shapes the entire peripheral side surface of a portion of the substrate 3 adjacent to the outer side surface 3B. A parting line PL of the molding space 64 of the molding die 6A according to this embodiment runs between the movable-die substrate molding region 616A and the fixed-die substrate molding region 606A.

In this embodiment, the movable-die substrate molding region 616A straddles the central piece 611 and the inner circumferential portion of the peripheral piece 610, while the rising region 609 is provided on the peripheral piece 610. Depressions in the peripheral piece 610 of the movable die 61 shape the runner 62 and the gate 63.

A film 4, which is indicated by the dotted lines in the drawing, is bonded to the area inside the peripheral portion of the inner side surface 3A of the substrate 3 which is shaped by the molding die 6A.

As described above, the same advantageous effects as those of the first embodiment are achieved in this embodiment. In addition, since the parting line PL of the molding space 64 runs between the movable-die substrate molding region 616A and the fixed-die substrate molding region 606A, the rising regions 608A and 609, which shape the peripheral side surface of the substrate, surround the peripheral portions of the movable-die substrate molding region 616A and the fixed-die substrate molding region 606A. The fixed die 60A is configured by including the central piece 601, which includes the fixed-die substrate molding region 606A, and the peripheral piece 600, which surrounds the fixed-die substrate molding region 606. A gap can be readily formed between the central piece 601 and the peripheral piece 600, which are joined together in the thickness direction of the substrate 3, promoting the formation of a flash B on the peripheral portion of the inner side surface 3A of the substrate 3 rising in a direction orthogonal to the inner side surface 3A.

With respect to this, according to the embodiment, the film 4 is attached to the substrate 3 on an area inside the peripheral portion of the inner side surface 3A. Thus, the microchip 2 can be manufactured without involving the flash B of the peripheral portion in the bonding of the film 4 and the substrate 3.

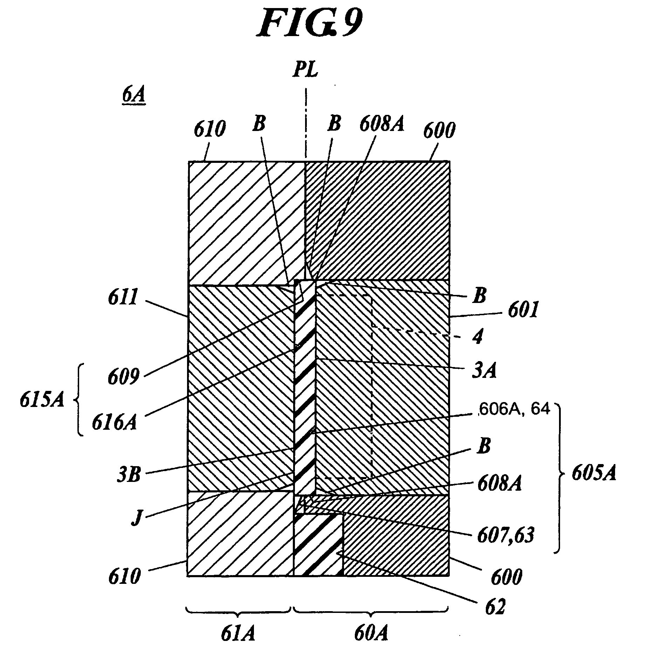

In the second embodiment, the depressions in the peripheral piece 610 of the movable die 61A shape the runner 62 and the gate 63. Alternatively, as illustrated in FIG. 9, the depressions in the peripheral piece 600 of the fixed die 60A may shape the runner 62 and the gate 63. The flash B is generated at the contacting portion of the peripheral piece 610 and the central piece 611 of the movable die 61 of the molding die 6A.

### [Third Embodiment]

The third embodiment of the present invention will now be described with reference to FIG. 10.

FIG. 10 is a schematic cross-sectional view of a molding die 6B in the embodiment.

With reference to the drawing, the molding die 6B includes a fixed die 60B and a movable die 61B, alternative to the fixed die 60 and the movable die 61 in the embodiment described above.

A movable-die molding surface 615B of the movable die 61B has a movable-die substrate molding region 616B.

The movable-die substrate molding region 616B shapes the outer side surface 3B of the substrate 3. Specifically, the movable-die substrate molding region 616B shapes a depression or a protrusion (hereinafter referred to as "depression/protrusion T") on the outer side surface 3B of the substrate 3. Referring to FIG. 3C, the depression/protrusion T, for example, is a cylindrical protrusion surrounding a through hole 31 in the outer side surface 3B.

A fixed-die molding surface 605B of the fixed die 60B has a rising region 608B, alternative to the rising region 608 according to the embodiment described above.

The rising region 608B surrounds the fixed-die substrate molding region 606 and shapes the entire peripheral side surface of the substrate 3 along the thickness direction. The parting line PL of the molding space 64 of the molding die 6B in the embodiment and the movable-die substrate molding region 616B are disposed on a single plane.

A film 4, which is indicated by the dotted lines in the drawing, is bonded to the substrate 3 shaped by the molding die 6B in the area inside the peripheral portion of the inner side surface 3A.

As described above, the same advantageous effects as those of the first embodiment are achieved in the embodiment. In addition, since the parting line PL of the molding space 64 and the movable-die substrate molding region 616B are disposed on a single plane, the rising region 608B, which shapes the peripheral side surface of the substrate 3, surrounds the peripheral portion of the fixed-die substrate molding region 606. The fixed die 60B is configured by including the central piece 601, which includes the fixed-die substrate molding region 606, and the peripheral piece 600, which surrounds the fixed-die substrate molding region 606. Thus, a gap can be readily formed between the central piece 601 and the peripheral piece 600, which are joined together in the thickness direction of the substrate 3, promoting the formation of a flash B on the peripheral portion of the inner side surface 3A of the substrate 3 in a direction orthogonal to the inner side surface 3A.

According to the embodiment, the film 4 is attached to the substrate 3 on an area inside the peripheral portion of the inner side surface 3A. Thus, the microchip 2 can be manufactured without involving the flash B of the peripheral portion in the bonding of the film 4 and the substrate 3.

The movable-die substrate molding region 616B shapes the depression/protrusion T on the outer side surface 3B of the substrate 3. Thus, even in a case where the substrate 3 is fit in the fixed die 60B for molding, the frictional resistance (demolding resistance) between the molded product and the movable die 61B is increased to facilitate the release of the molded product from the fixed die 60B.

The present invention is not limited to the embodiments described above, and various modifications of the embodiments may be employed within the scope of the invention.

### INDUSTRIAL APPLICABILITY

As described above, the present invention is suitable for a molding die, a microchip, and a manufacturing apparatus of the microchip that can reduce the adverse effects of flashes and bulges.

### EXPLANATION OF REFERENCE NUMERALS

3 substrate
4 film (cover)
6, 6A, 6B molding die
3A inner side surface (one surface)
3B outer side surface (the other surface)
60 fixed die (first die)
61 movable die (second die)
63 gate
64 molding space
606 fixed-die substrate molding region
607 gate-defining region
608, 608A, 608B rising region
616A, 616B movable-die substrate molding region
PL parting line
T depression/protrusion (depression or protrusion)

## Claims

1. A molding die (6) for molding a substrate (3) to be included in a microchip (2), the molding die comprising:
a first die (60); and
a second die (61) contactable with and separable from the first die,
wherein the microchip (2) is formed by forming a fluid passage groove (30) on one surface of the substrate (3) and attaching a cover (4) to the one surface,
**characterized in that**
a molding space (64) for molding the substrate and a gate (63) for introducing resin into the molding space are formed between the first die and the second die,
a molding surface of the first die (605) includes:
a first-die substrate molding region (606) which molds the one surface of the substrate;
a gate-defining region (607) which defines the gate (63); and
a rising region (608) which is located between the gate-defining region and the first-die substrate molding region and extends from an edge of the first-die substrate molding region toward the second die, and
the gate-defining region is closer to the second die than the first-die substrate molding region.

2. The molding die of claim 1, wherein a parting line (PL) of the molding space and the first-die substrate molding region are located on a single plane.

3. The molding die of claim 1, wherein
a molding surface (615A) of the second die includes a second-die substrate molding region which molds the other surface of the substrate,
a parting line (PL) of the molding space is located between the second-die substrate molding region and the first-die substrate molding region, and
the cover is attached to the substrate on an area inside a peripheral portion of the one surface.

4. The molding die of claim 1, wherein
a molding surface of the second die includes a second-die substrate molding region which molds the other surface of the substrate,
a parting line of the molding space and the second-die substrate molding region are located on a single plane, and
the cover is attached to the substrate on an area inside a peripheral portion of the one surface.

5. The molding die of claim 4, wherein the second-die substrate molding region molds a depression or a protrusion on the other surface of the substrate.

6. A microchip in which a substrate and a cover are attached to each other,
wherein
the microchip is formed by attaching the cover to one surface of the substrate, and
**characterized in that** the substrate is molded with the molding die of any one of claims 1 to 5.

7. The microchip of claim 6, wherein a portion (G) molded by the gate is cut in a direction from the second die to the first die.

8. A microchip manufacturing apparatus for manufacturing a microchip having a substrate and a cover attached hereto,
**characterized in** comprising the molding die of any one of claims 1 to 5 for molding the substrate.

## Patentansprüche

1. Formmatrize (6) zum Formen eines Substrats (3), welches in einen Mikrochip integriert werden soll, wobei die Formmatrize aufweist:
eine erste Matrize (60); und
eine zweite Matrize (61), die mit der ersten Matrize in Kontakt gebracht und von dieser getrennt werden kann,
wobei der Mikrochip (2) durch Bilden einer Fluiddurchgangsrille (30) auf einer Seite des Substrats (3) und Befestigen einer Abdeckung (4) auf der anderen Seite gebildet wird,
**dadurch gekennzeichnet, dass**
ein Formraum (64) zum Formen des Substrats und eine Einlassöffnung (63) zum Einleiten von Harz in den Formraum zwischen der ersten Matrize und der zweiten Matrize gebildet werden,
wobei eine Formfläche der ersten Matrize (605) aufweist:
einen Substratformbereich (606) der ersten Matrize, welcher die eine Fläche des Substrats formt;
einen eine Öffnung definierenden Bereich (607), welcher die Einlassöffnung (63) definiert; und
einen ansteigenden Bereich (608), der zwischen dem eine Öffnung definierenden Bereich und dem Substratformbereich der ersten Matrize angeordnet ist und sich von einer Kante des Substratformbereichs der ersten Matrize zu der zweiten Matrize hin erstreckt, und
wobei der eine Öffnung definierende Bereich näher an der zweiten Matrize liegt als der Substratformbereich der ersten Matrize.

2. Formmatrize gemäß Anspruch 1, wobei eine Trennlinie (PL) zwischen dem Formraum und dem Substratformbereich der ersten Matrize in einer einzigen Ebene liegt.

3. Formmatrize gemäß Anspruch 1, wobei
eine Formfläche (615A) der zweiten Matrize einen Substratformbereich der zweiten Matrize aufweist, welcher die andere Seite des Substrats formt,
eine Trennlinie (PL) des Formraums zwischen dem Substratformbereich der zweiten Matrize und dem Substratformbereich der ersten Matrize angeordnet ist; und
die Abdeckung an einem Bereich innerhalb eines Umfangsbereichs der einen Seite an dem Substrat befestigt wird.

4. Formmatrize gemäß Anspruch 1, wobei
eine Formfläche der zweiten Matrize einen Substratformbereich der zweiten Matrize aufweist, welcher die andere Seite des Substrats formt,
eine Trennlinie zwischen dem Formraum und dem Substratformbereich der zweiten Matrize in einer einzigen Ebene angeordnet ist; und
die Abdeckung an einem Bereich innerhalb eines Umfangsbereichs der einen Seite an dem Substrat befestigt wird.

5. Formmatrize gemäß Anspruch 4, wobei der Substratformbereich der zweiten Matrize eine Vertiefung oder eine Vorwölbung in die andere Seite des Substrats formt.

6. Mikrochip, bei welchem ein Substrat und eine Abdeckung aneinander befestigt sind,
wobei
der Mikrochip gebildet wird, indem die Abdeckung an einer Seite des Substrats befestigt wird, und
**dadurch gekennzeichnet, dass** das Substrat mit der Formmatrize gemäß irgendeinem der Ansprüche 1 bis 5 geformt wird.

7. Mikrochip gemäß Anspruch 6, wobei ein von der Einlassöffnung geformter Bereich (G) in einer Richtung von der zweiten Matrize zu der ersten Matrize hin geschnitten wird.

8. Herstellungsvorrichtung für Mikrochip zur Herstellung eines Mikrochips mit einem Substrat und einer daran befestigten Abdeckung, **dadurch gekennzeichnet, dass** sie die Formmatrize gemäß irgendeinem der Ansprüche 1 bis 5 zum Formen des Substrats aufweist.

## Revendications

1. Matrice de moulage (6) destinée à mouler un substrat (3) à incorporer dans une micro-puce (2), la matrice de moulage comprenant :
une première matrice (60) ; et
une deuxième matrice (61) pouvant être mise en contact avec et séparée de la première matrice,
la micro-puce (2) étant formée en formant une rainure de passage de fluide (30) sur une surface du substrat (3) et en fixant une couverture (4) à l'une surface,
**caractérisée en ce qu'**
un espace de moulage (64) pour mouler le substrat et une ouverture (63) pour introduire de la résine dans l'espace de moulage sont formés entre la première matrice et la deuxième matrice,
une surface de moulage (605) de la première matrice comprenant :
une région de moulage de substrat (606) de la première matrice qui moule l'une surface du substrat ;
une région définissant une ouverture (607) qui définit l'ouverture (63) ; et
une région ascendant (607) qui est disposée entre la région définissant une ouverture et la région de moulage de substrat de la première matrice et qui s'étend à partir d'un bord de la région de moulage de substrat de la première matrice jusqu'à la deuxième matrice, et
la région définissant une ouverture se trouve plus proche de la deuxième matrice que la région de moulage de substrat de la première matrice.

2. Matrice de moulage selon la revendication 1, dans laquelle une ligne de partage (PL) de l'espace de moulage et de la région de moulage de substrat de la première matrice est disposée dans un seul plan.

3. Matrice de moulage selon la revendication 1, dans laquelle
une surface de moulage (615A) de la deuxième matrice comprend une région de moulage de substrat de la deuxième matrice qui moule l'autre surface du substrat,
une ligne de partage (PL) de l'espace de moulage est disposée entre la région de moulage de substrat de la deuxième matrice et la région de moulage de substrat de la première matrice, et
la couverture est fixée au substrat dans une région à l'intérieur d'une partie périphérique de l'une surface.

4. Matrice de moulage selon la revendication 1, dans laquelle
une surface de moulage de la deuxième matrice comprend une région de moulage de substrat de la deuxième matrice qui moule l'autre surface du su bstrat,
une ligne de partage de l'espace de moulage et de la région de moulage de substrat de la deuxième matrice est disposée dans un seul plan, et
la couverture est fixée au substrat dans une région à l'intérieur d'une partie périphérique de l'une surface.

5. Matrice de moulage selon la revendication 4, dans laquelle la région de moulage de substrat de la deuxième matrice moule une cavité ou une protubérance dans l'autre surface du substrat.

6. Micro-puce dans laquelle un substrat et une couverture sont fixés l'un à l'autre,
la micro-puce étant formée en fixant la couverture à une surface du substrat, et
**caractérisée en ce que** le substrat est moulé par la matrice de moulage selon l'une quelconque des revendications 1 à 5.

7. Micro-puce selon la revendication 6, dans laquelle une partie (G) moulée par l'ouverture est coupée dans une direction de la deuxième matrice à la première matrice.

8. Dispositif de fabrication de micro-puces destiné à fabriquer une micro-puce comprenant un substrat et une couverture fixée à celle-ci,
**caractérisé en ce que** le dispositif comprend la matrice de moulage selon l'une quelconque des revendications 1 à 5 pour mouler le substrat.
